# EUROPEAN PATENT APPLICATION

(11) **EP 1 160 986 A1**
(43) Date of publication of application: **05.12.2001**
(21) Application number: 00304648.9
(22) Date of filing: 31.05.2000
(51) Int. Cl.: H03M 1/66

(54) **Circuit arrangement for digital-to-analog conversion**

(71) Applicant: LUCENT TECHNOLOGIES INC., Murray Hill, New Jersey 07974-0636 (US)
(72) Inventor: Fischer, George, 90419 Nürnberg (DE); Ritter, Kai Uwe, 91154 Roth (DE)
(74) Representative: Watts, Christopher Malcolm Kelway, Dr.

(57) **Abstract**

The invention relates to a circuit arrangement (10) for digital-to-analog conversion of a data stream.

Ever faster digital-to-analog converters with high resolution are demanded nowadays for the digital-to-analog conversion of a data stream.

In order to be able to realize both performance features in a cost-effective circuit arrangement, provision is made of a device (20) for splitting the data stream into at least two data streams with a clock rate of 1/(Tᵢₙ/n) in each case, where n is greater than or equal to 2. Furthermore, provision is made of at least two digital-to-analog converters (30, 35; 80, 82, 84, 86) for converting a respective one of the partial data streams with a conversion clock rate of 1/(Tᵢₙ/n) and, furthermore, of a device (40; 50) for combining the converted partial data streams.

## Description

The invention relates to a circuit arrangement for the digital-to-analog conversion of a data stream in accordance with the preamble of Claim 1.

In the field of digital transmission technology, digital-to-analog converters are used to convert numbers into voltages which are proportional thereto. In GSM base stations, in particular, digital-to-analog converters which operate very fast and have a high resolution are desirable. However, since fast digital-to-analog converters which operate precisely cannot be produced with the aid of cost-effective CMOS processes, complicated and expensive production processes have to be provided for them.

The invention is based on the object, therefore, of providing a circuit arrangement for digital-to-analog conversion which can operate with very fast conversion clock rates and a high resolution, where digital-to-analog converters that are used can be produced by customary CMOS processes.

The invention solves this technical problem with the features of Claim 1.

Accordingly, a circuit arrangement for the digital-to-analog conversion of a data stream with a predetermined clock rate of 1/T_{IN} is provided which has a device for splitting the data stream into at least two partial data streams with a clock rate of 1/(T_{IN}/n) in each case, where n is greater than or equal to 2. Furthermore, the circuit arrangement contains at least two digital-to-analog converters for converting a respective one of the partial data streams with a conversion clock rate of 1/(T_{IN}/n), and also a device for combining the converted partial data streams. The conversion clock rate specifies how many numbers - represented by bits - per second are converted into a corresponding analog value, e.g. voltage value.

The conversion clock rates are supplied by an appropriately designed device from a predetermined clock signal. Furthermore, this device delays the conversion clock rates in such a way that the conversion clock rates are in each case staggered over time relative to one another by a predetermined amount. If the digital-to-analog converters are able to supply, at the output, pulses having a narrow pulse width which is less than half of the minimum conversion clock duration, the combination device may be a simple summation device.

If a rapidly switchable multiplexer is used as the combination device, it is possible to use slow digital-to-analog converters which supply customary stepped output signals instead of pulsed output signals. In this case, the digital-to-analog converters can be produced cost-effectively by CMOS processes, whereas the rapidly switchable multiplexer can be produced in a GaAs process, for example.

The invention is explained in more detail below using the exemplary embodiments in conjunction with the accompanying drawings, in which:
- Figure 1: shows the block diagram of a circuit arrangement for digital-to-analog conversion according to the invention, with two digital-to-analog converters,
- Figure 2: shows an alternative circuit arrangement for digital-to-analog conversion, with four digital-to-analog converters,
- Figure 3: shows the output signal of the first digital-to-analog converter shown in Figure 1,
- Figure 4: shows the output signal of the second digital-to-analog converter according to Figure 2, and
- Figure 5: shows the output signal of the summation device.

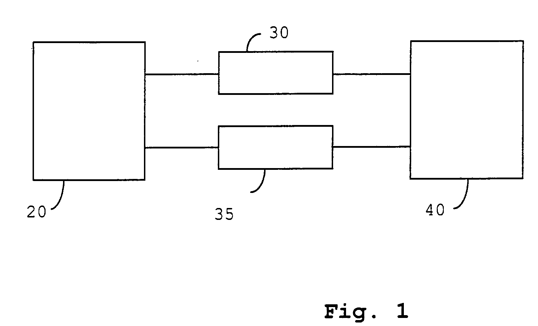

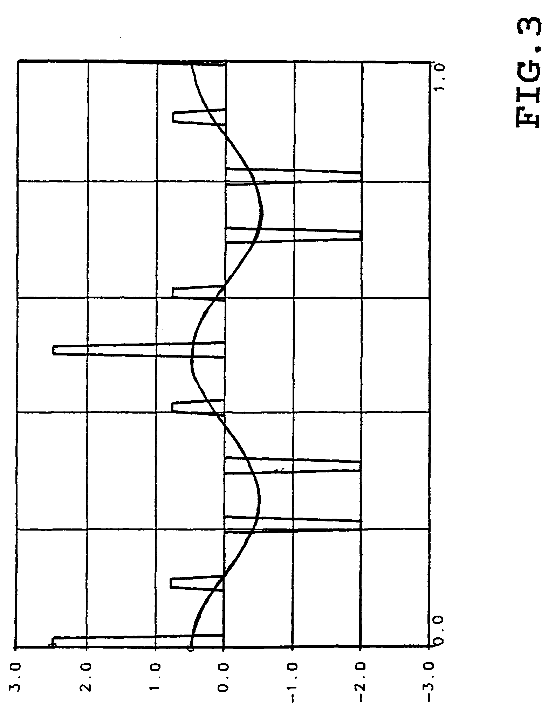

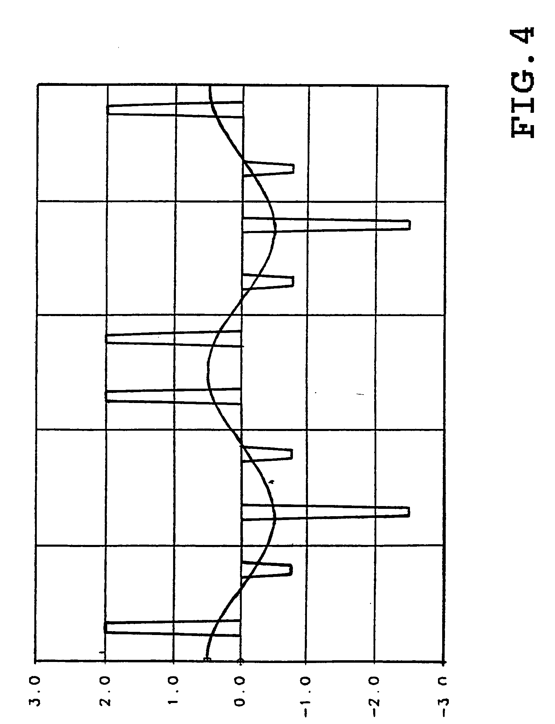

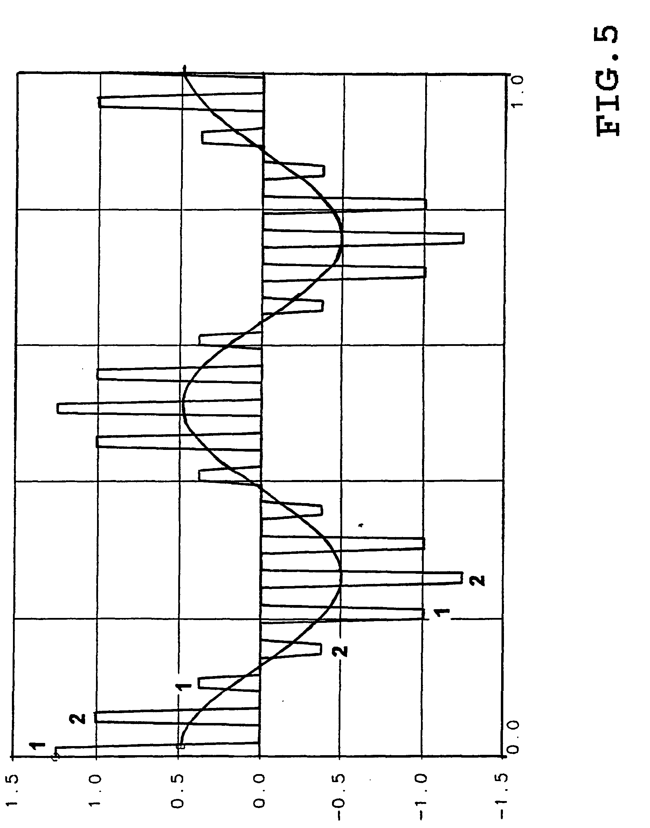

Figure 1 shows a circuit arrangement 10 for digital-to-analog conversion, which has, on the input side, a device 20, also called data splitter below, which splits an applied data stream with a clock rate of 1/T_{IN} into, for example, two partial data streams with a clock rate of 1/(T_{IN}/2) in each case. Each partial data stream is fed via a separate digital-to-analog converter 30 and 35, respectively, to a summation device 40, which converts the output signals of the two digital-to-analog converters 30 and 35 into an output signal with the clock rate 1/T_{IN}. To that end, the digital-to-analog converters must have rapidly activatable switches at the output, in order that the output pulses can be added with correct timing in the summation device 40. The conversion clock rates of the two digital-to-analog converters 30 and 35 are delayed temporally with respect to one another by T_{IN}/4, for example, as is illustrated in Figure 5. To ensure that the pulse output signals of the digital-to-analog converters 30 and 35 can be summed without interfering with one another in the summation device 40, it is necessary for the pulse width to be less than half of the shortest conversion clock duration. Figure 3 shows the pulse output signal of the digital-to-analog converter 30, whereas Figure 4 illustrates the pulse output signal of the digital-to-analog converter 35 delayed by T_{IN}/4. The summation signal formed in the summation device 40 is illustrated in Figure 5, the solid pulses representing the output signal of the digital-to-analog converter 30 and the broken pulses representing the output signal of the digital-to-analog converter 35.

The data stream arriving at the data splitter 20 has a clock rate of 20 msps (mega samples per second), for example, whereas the two digital-to-analog converters 30 and 35 each have a conversion clock rate of 10 msps. With the aid of the circuit arrangement 10, therefore, it is possible to convert a high-speed data stream into a corresponding analog signal with the aid of a plurality of slower conventional digital-to-analog converters, by the analog signal shown in Figure 5 subsequently being fed to a low-pass filter.

Furthermore, such a circuit arrangement exhibits a more constant frequency response by comparison with a single, very fast digital-to-analog converter. Moreover, with the converter resolution (corresponds to the number of bits) remaining the same, the clock rate of the processing data signal can be increased.

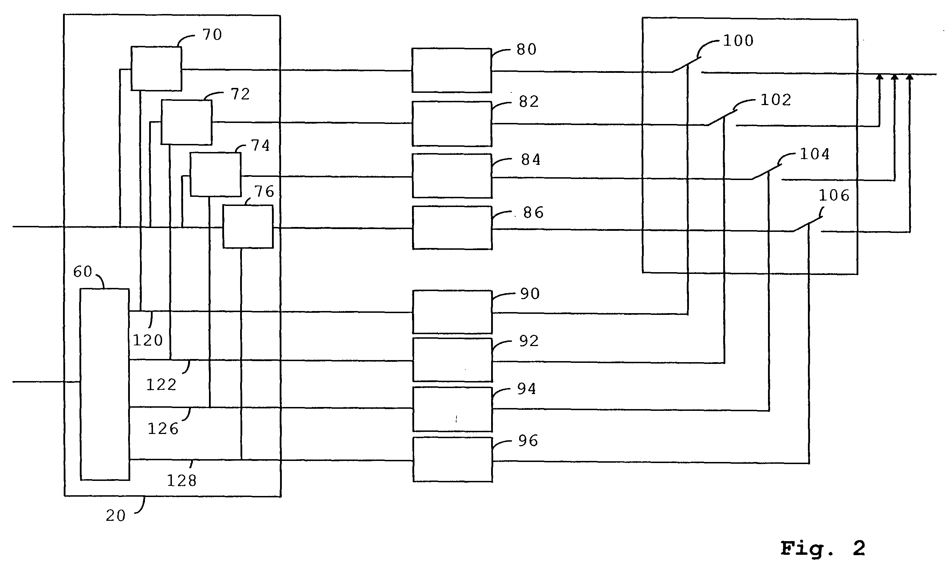

Figure 2 shows an alternative circuit arrangement 10, which uses a multiplexer 50 instead of a summation device 40, the said multiplexer being represented schematically by four switches 100, 102, 104, 106. A data splitter 20 again forms the input of the circuit arrangement 10. By way of example, ten parallel input lines are connected to the data splitter 20, via which input lines a data stream with a clock rate of 20 msps, for example, is applied. Furthermore, a 20-MHz clock signal is applied to the data splitter 20 on the input side, which clock signal is divided down into four clock signals with a clock rate of 5 MHz in each case by means of a clock divider and clock delay device 60. The divided-down clock signals correspond to the conversion clock rates of the digital-to-analog converters 80, 82, 84 and 86. In the data splitter 20, the input data stream is divided between four buffers 70, 72, 74 and 76, to each of which a different conversion clock rate is fed. In the present example, each conversion clock rate provided by the clock divider and clock delay device 60 is shifted by T_{IN}/4 relative to the following conversion clock rate. In other words, by way of example, the undelayed conversion clock rate is applied to the buffer 70 via the line 120, the conversion clock rate delayed by T_{IN}/4 relative to the undelayed conversion clock rate is applied to the buffer 72 via the line 122, the conversion clock rate delayed by T_{IN}/2 relative to the undelayed conversion clock rate is applied to the buffer 74 via the line 124 and the conversion clock rate delayed by 3T_{IN}/4 relative to the undelayed conversion clock rate is applied to the buffer 76 via the line 126. In this way, the 20-msps data input signal is converted into four partial data streams with a clock rate of 5 msps in such a way that the first, fifth, ninth etc. bit of the data input stream are buffer-stored in the buffer 70, the second, sixth, tenth, etc. bit of the data input stream are buffer-stored in the buffer 72, the third, seventh, eleventh, etc. bit of the data input stream are buffer-stored in the buffer 74 and the fourth, eighth, twelfth, etc. bit of the data input stream are buffer-stored in the buffer 76. The buffers 70, 72, 74 and 76 can be designed as shift registers which forward the buffer-stored bits in time with the respectively applied conversion clock rate to the digital-to-analog converters 80, 82, 84 and 86 respectively connected downstream.

The conversion clock rates output in a temporally delayed manner by the clock divider and delay device 60 are fed via the lines 120, 122, 124 and 126, via delay elements 90, 92, 94 and 96, to the switches 100, 102, 104 and 106, respectively, which form the multiplexer 50. The delay elements 90 to 96 take account of the settling time of the digital-to-analog converters 80, 82, 84 and 86. This ensures that the output signals of the digital-to-analog converters 80, 82, 84 and 86 are switched through in the correct order and with the correct time delay, such that the output signal of the multiplexer 50 mirrors the summation signal of the four output signals of the digital-to-analog converters. The output signal of the multiplexer 50 in this case corresponds to the output signal of the summation device 40 in accordance with Figure 1.

The digital-to-analog converters 80, 82, 84 and 86 shown in Figure 2 may be conventional digital-to-analog converters produced by means of CMOS processes. Only the switches 100, 102, 104 and 106 have to be very rapidly switchable and, to that end, are produced by means of GaAs processes, for example.

## Claims

1. Circuit arrangement for the digital-to-analog conversion of a data stream with a predetermined clock rate of 1/T_{IN}, **characterized by**
a device (20) for splitting the data stream into at least two partial data streams with a clock rate of 1/(T_{IN}/n) in each case, where n is greater than or equal to two,
at least two digital-to-analog converters (30, 35; 80, 82, 84, 86) for converting a respective one of the partial data streams with a conversion clock rate of 1/(T_{IN}/n), and
a device (40; 50) for combining the converted partial data streams.

2. Circuit arrangement according to Claim 1, **characterized by**
a device (60) for generating the conversion clock rates from a predetermined clock signal and for temporally delaying the conversion clock rates in such a way that the conversion clock rates are in each case staggered over time relative to one another by a predetermined amount.

3. Circuit arrangement according to Claim 1 or 2, **characterized in that** the output signals of the digital-to-analog converters are pulse signals and the combination device is a summation device (40).

4. Circuit arrangement according to Claim 1 or 2, **characterized in that** the combination device is a multiplexer (50) controlled by the conversion clock rates.
